# EUROPEAN PATENT APPLICATION

(11) **EP 4 613 916 A1**
(43) Date of publication of application: **10.09.2025**
(21) Application number: 23885563.9
(22) Date of filing: 23.10.2023
(51) Int. Cl.: C30B 29/04, C23C 16/27, C23C 16/511

(54) **BORON-DOPED SINGLE CRYSTAL DIAMOND FILM**

(30) Priority: 04.11.2022 JP 2022176978
(71) Applicant: EDP Corporation, Toyonaka-shi, Osaka 560-0085 (JP)
(72) Inventor: FURUHASHI, Masayuki, Toyonaka-shi, Osaka 560-0085 (JP); FUJIMORI, Naoji, Toyonaka-shi, Osaka 560-0085 (JP)
(74) Representative: Müller-Boré & Partner Patentanwälte PartG mbB
(86) International application number: PCT/JP2023/038141
(87) International publication number: WO 2024/095803

(57) **Abstract**

There is provided a novel boron-doped single-crystal diamond film that has an increased concentration of boron contained in the boron-doped single-crystal diamond film, and also has a controlled plane orientation and a controlled thickness, has an increased area and a reduced resistivity, and is easy to produce. A boron-doped single-crystal diamond film having a boron concentration of 2 × 10²⁰ atms/cm³ or more, a metal element concentration of less than 1 × 10¹⁶ atms/cm³, a nitrogen concentration of 0.2 ppm or less, a thickness in a range of 10 to 500 µm, and an off-angle in a {001} plane orientation in a range of 0.1 to 4.0°.

## Description

### Technical Field

The present invention relates to a boron-doped single-crystal diamond film.

### Background Art

Diamond has excellent physical properties, such as high dielectric breakdown field, high carrier mobility, and the highest thermal conductivity among substances, and also has excellent chemical stability and radiation resistance. This makes diamond promising for applications as power device materials that operate under a high-temperature and extreme environment.

### Citation List

### Patent Literature

Patent Literature 1: JP 2010-150069 A

### Summary of Invention

### Technical Problem

Various diamond films doped with impurities such as boron have heretofore been proposed. Among such diamond films that have been studied and reported are a diamond film having an extremely high impurity concentration in the diamond film; a diamond film with an increased area obtained by bonding diamond films to one another; a diamond film doped with a metal element; and a diamond film with a controlled plane orientation. However, for mass production and practical use of a diamond film as a power device material, the diamond film is required to have an increased concentration of an impurity, such as boron, contained in the diamond film, and also to have a controlled plane orientation and a controlled thickness, to have an increased area and a reduced resistivity, and to be easy to produce (for example, easy to be mass-produced).

It is a main object of the present invention to provide a novel boron-doped single-crystal diamond film that has an increased concentration of boron contained in the boron-doped single-crystal diamond film, and also has a controlled plane orientation and a controlled thickness, has an increased area and a reduced resistivity, and is easy to produce.

### Solution to Problem

The present inventors have conducted extensive research to solve the aforementioned problem. As a result, the inventors have found that when the composition of a carrier gas for depositing a boron-doped single-crystal diamond film is devised so that the boron-doped single-crystal diamond film has a boron concentration of 2 × 10²⁰ atms/cm³ or more, a metal element concentration of less than 1 × 10¹⁶ atms/cm³, a nitrogen concentration of 0.2 ppm or less, a thickness in a range of 10 to 500 µm, and an off-angle in a {001} plane orientation in a range of 0.1 to 4.0°, a novel boron-doped single-crystal diamond film can be obtained that has an increased concentration of boron contained in the boron-doped single-crystal diamond film, and also has a controlled plane orientation and a controlled thickness, has an increased area and a reduced resistivity, and is easy to produce. The present invention has been completed as a result of further research based on this finding.

In summary, the present invention provides the following aspects of the invention:
Item 1. A boron-doped single-crystal diamond film having:
   a boron concentration of 2 × 10²⁰ atms/cm³ or more,
   a metal element concentration of less than 1 × 10¹⁶ atms/cm³,
   a nitrogen concentration of 0.2 ppm or less,
   a thickness in a range of 10 to 500 µm, and
   an off-angle in a {001} plane orientation in a range of 0.1 to 4.0°.
Item 2. The boron-doped single-crystal diamond film according to item 1, wherein one surface of the boron-doped single-crystal diamond film has an area of 9 mm² or more.
Item 3. The boron-doped single-crystal diamond film according to item 1 or 2, wherein the boron-doped single-crystal diamond film is a free-standing film.
Item 4. The boron-doped single-crystal diamond film according to any one of items 1 to 3, wherein the boron-doped single-crystal diamond film is stacked on a single-crystal diamond substrate.
Item 5. A diamond stack comprising a single-crystal diamond substrate; and the boron-doped single-crystal diamond film according to any one of items 1 to 4 stacked on the single-crystal diamond substrate.
Item 6. A method for producing the boron-doped single-crystal diamond film according to any one of items 1 to 4, sequentially comprising:
   step (1) of introducing a carrier gas containing at least a carbon source, a boron source, and an oxygen source into a vacuum apparatus in which a substrate is placed; and
   step (2) of converting the carrier gas into a plasma to deposit a single-crystal diamond film containing boron on the substrate.
Item 7. The method according to item 6, further comprising, after the step (2), step (3) of separating the single-crystal diamond film containing boron from the substrate.

### Advantageous Effects of Invention

According to the present invention, it is possible to provide a novel boron-doped single-crystal diamond film that has an increased concentration of boron contained in the boron-doped single-crystal diamond film, and also has a controlled plane orientation and a controlled thickness, has an increased area and a reduced resistivity, and is easy to produce.

### Description of Embodiments

A boron-doped single-crystal diamond film of the present invention has a boron concentration of 2 × 10²⁰ atms/cm³ or more, a metal element concentration of less than 1 × 10¹⁶ atms/cm³, a nitrogen concentration of 0.2 ppm or less, a thickness in a range of 10 to 500 µm, and an off-angle in a {001} plane orientation in a range of 0.1 to 4.0°. The boron-doped single-crystal diamond film of the present invention will be hereinafter described in detail.

The boron-doped single-crystal diamond film of the present invention may be present in the state of being stacked on a substrate (diamond stack). Alternatively, the boron-doped single-crystal diamond film of the present invention may be present as a free-standing film independent of the substrate. The single-crystal diamond film of the present invention can be suitably produced, for example, through the steps of providing a single-crystal diamond substrate and growing a boron-doped single-crystal diamond film in a gas that satisfies a predetermined composition. A method for producing the boron-doped single-crystal diamond film of the present invention will be described in detail later.

In addition to the substrate and the boron-doped single-crystal diamond film, other layers may be stacked on the diamond stack (a stack including at least a substrate and the boron-doped single-crystal diamond film stacked on the substrate) according to the use of the stack. The other layers are not specifically limited and may be known layers (for example, an electrode, an insulating film, and other semiconductor films) that are stacked when diamond is used as power device materials.

When the boron-doped single-crystal diamond film of the present invention is present in the state of being stacked on a substrate (in the state of being included in the diamond stack), the boron-doped single-crystal diamond film preferably has a stacked structure in which at least the boron-doped single-crystal diamond film is stacked on the substrate. The substrate is preferably a single-crystal diamond substrate. In the diamond stack, the thickness of the substrate may be appropriately adjusted according to the use of the diamond stack, and is, for example, about 200 to 1000 µm.

The thickness (film thickness) of the boron-doped single-crystal diamond film of the present invention is in the range of 10 to 500 µm, and can be appropriately selected according to the use, for example. The thickness of the boron-doped single-crystal diamond film of the present invention is preferably 20 µm or more, more preferably 30 µm or more, still more preferably 40 µm or more, and even more preferably 50 µm or more. The upper limit of the thickness is preferably 400 µm or less. When the boron-doped single-crystal diamond film of the present invention is formed as a free-standing film, the thickness of the boron-doped single-crystal diamond film is preferably 100 µm or more.

One surface of the boron-doped single-crystal diamond film of the present invention has an area of preferably 9 mm² or more, more preferably 16 mm² or more, still more preferably 25 mm² or more. The upper limit of the area is, for example, 4500 mm² or less.

A difference between maximum and minimum values of the thickness of the boron-doped single-crystal diamond film of the present invention is preferably 10% or less of the maximum value of the thickness, more preferably 5% or less of the maximum value of the thickness, and still more preferably 3% or less of the maximum value of the thickness.

In the boron-doped single-crystal diamond film of the present invention, the boron concentration may be any in the range of 2 × 10²⁰ atms/cm³ or more; however, the boron concentration is preferably 3 × 10²⁰ atms/cm³ or more, and more preferably 4 × 10²⁰ atms/cm³ or more, while the boron concentration is preferably 3 × 10²¹ atms/cm³ or less, and more preferably 2 × 10²¹ atms/cm³ or less. Preferred ranges include from 2 × 10²⁰ to 3 × 10²¹ atms/cm³ and from 3 × 10²⁰ to 2 × 10²¹ atms/cm³.

For example, when an impurity other than elemental boron is to be incorporated into the diamond film, the impurity other than boron can be incorporated into the diamond film by using a nitrogen source, a metal source, and the like together with a gas serving as a carbon source (such as methane) and a gas serving as a boron source (such as trimethylboron) when forming the diamond film by a chemical vapor deposition method. The upper limit of the concentration of the impurity other than boron in the diamond film is, for example, 1 × 10¹⁶ atms/cm³ or less, more preferably 5 × 10¹⁵ atms/cm³ or less, and still more preferably 1 × 10¹⁵ atms/cm³ or less.

The concentration of the impurity in the diamond film is the value as measured by secondary ion mass spectrometry (SIMS), and is measured by the method as specifically described in the Examples.

The single-crystal diamond film of the present invention may or may not contain the impurity other than boron. Examples of the impurity other than boron include nitrogen and metals (metal elements).

The boron-doped single-crystal diamond film of the present invention can be produced, for example, by a chemical vapor deposition method such as the microwave CVD method. The microwave CVD method is particularly suitable. It should be noted that when a diamond film is formed by the hot filament CVD method using a metal filament, the metal constituting the metal filament is included in the diamond film, resulting in a diamond film doped with the metal. In this case, the metal element concentration in the boron-doped single-crystal diamond film exceeds 1 × 10¹⁶ atms/cm³, and thus, the hot filament CVD method is undesirable for use as the production method of the present invention. By using the microwave CVD method, the metal element concentration in the boron-doped single-crystal diamond film can be controlled to less than 1 × 10¹⁶ atms/cm³.

In the boron-doped single-crystal diamond film of the present invention, the metal element concentration may be any in the range of less than 1 × 10¹⁶ atms/cm³; however, the metal element concentration is preferably 5 × 10¹⁵ atms/cm³ or less, and more preferably 1 × 10¹⁵ atms/cm³ or less. The lower limit of the metal element concentration is, for example, 1 × 10¹² atms/cm³ or 0 atms/cm³. The type of the metal element is not specifically limited as long as it can form a boron-doped single-crystal diamond film, and examples include tungsten, tantalum, rhenium, ruthenium, and silicon. When the metal element is included in the boron-doped single-crystal diamond film of the present invention, the metal element may be a single metal element or two or more metal elements.

In the single-crystal diamond film of the present invention, the nitrogen content may be any in the range of 0.2 ppm or less, but is preferably 0.1 ppm or less, and more preferably 0.05 ppm or less. A preferred range is, for example, from 0.01 ppb to 0.2 ppm.

When the boron-doped single-crystal diamond film of the present invention is stacked on a single-crystal diamond substrate, the single-crystal diamond substrate has a boron concentration of preferably 1 × 10¹⁵ atms/cm³ or less, more preferably 5 × 10¹⁴ atms/cm³ or less, still more preferably 1 × 10¹⁴ atms/cm³ or less. Preferred ranges include from 1 × 10¹² to 1 × 10¹⁵ atms/cm³ and from 1 × 10¹³ to 1 × 10¹⁵ atms/cm³.

Furthermore, when the boron-doped single-crystal diamond film of the present invention is stacked on a single-crystal diamond substrate, the boron-doped single-crystal diamond film is preferably stacked on a {001} plane of the surface of the single-crystal diamond substrate.

The boron-doped single-crystal diamond film of the present invention has a resistivity of preferably 100 mΩ cm or less, more preferably 50 mΩ cm or less, still more preferably 20 mΩ cm or less.

The resistivity of the boron-doped single-crystal diamond film of the present invention is measured by the method described in the Examples.

The method for producing the boron-doped single-crystal diamond film of the present invention is not specifically limited as long as the method can produce the boron-doped single-crystal diamond film of the present invention. A preferred example of the method for producing the boron-doped single-crystal diamond film of the present invention will be hereinafter described.

The boron-doped single-crystal diamond film of the present invention can be suitably produced by a method comprising at least the following steps (1) and (2):
Step (1): introducing a carrier gas containing at least a carbon source, a boron source, and an oxygen source into a vacuum apparatus in which a substrate is placed.
Step (2): converting the carrier gas into a plasma to deposit a single-crystal diamond film containing boron on the substrate.

In step (1), the substrate placed in the vacuum vessel is not specifically limited as long as the carbon and boron contained in the carrier gas can be deposited on the substrate to allow growth of a boron-doped single-crystal diamond having a single-crystal structure of diamond in the below-described step (2).

Specific examples of the substrate include single-crystal diamond, 3C-silicon carbide, iridium, and platinum. Among these, a single-crystal diamond substrate is preferred. The substrate has an off-angle set to allow growth of a boron-doped single-crystal diamond on the {001} plane in step (2). For example, when the substrate is a single-crystal diamond substrate, the {001} off-angle of the substrate is preferably 10° or less, and more preferably 5° or less, for example.

In step (1), the vacuum vessel is placed under a vacuum state, and then the carrier gas containing a carbon source, a boron source, and an oxygen source is introduced into the vacuum vessel.

The carbon source is not specifically limited as long as it can form diamond, and may be, for example, methane. A single carbon source or a combination of two or more carbon sources may be used.

The boron source is preferably diborane or tetramethylboron (TMB), and particularly preferably TMB, for example. A single boron source or a combination of two or more boron sources may be used.

Examples of the oxygen source include an oxygen gas.

The carrier gas is not specifically limited and may be, for example, a hydrogen gas.

The concentration of the carbon source in the carrier gas is preferably about 2 to 10% by volume, and more preferably about 4 to 8% by volume.

The concentration of the boron source relative to that of the carbon source in the carrier gas is appropriately set according to the concentration of boron to be included in the boron-doped single-crystal diamond.

The concentration of oxygen atoms relative to that of carbon atoms in the carrier gas is set to prevent formation of soot in the vacuum apparatus in step (2) and impart a resistivity of preferably 100 mΩ cm or less, for example, to the boron-doped single-crystal diamond film deposited. From the viewpoint of suitably depositing the boron-doped single-crystal diamond film of the present invention, the concentration of the oxygen source in the carrier gas is preferably about 0.01 to 1% by volume, and more preferably about 0.1 to 0.5% by volume.

Step (2) performs the film deposition step of converting the carrier gas into a plasma by, for example, electromagnetic heating, to deposit a boron-doped single-crystal diamond film on the substrate.

A preferred heating method is microwave heating, for example. That is, the chemical vapor deposition method for depositing the boron-doped single-crystal diamond film is not limited, but is preferably the microwave CVD method, as described above.

The total pressure inside the vacuum vessel in step (2) is not specifically limited and is, for example, about 30 to 160 Torr, and preferably about 90 to 130 Torr.

The temperature of the substrate in step (2) is not specifically limited and may be, for example, about 700 to 1200°C, and more preferably about 800 to 1100°C.

The film deposition time in step (2) may be appropriately selected according to the desired thickness, for example, and is usually about 3 to 120 hours.

In the film deposition step of step (2), the concentration of the impurity in the single-crystal diamond can be adjusted to 2 × 10²⁰ cm³ or more. By adjusting each of the concentration of boron atoms and the concentration of oxygen atoms relative to that of carbon atoms in the carrier gas to 4000 ppm or more and 20% or less, the boron concentration can be adjusted to 2 × 10²⁰ cm³ or more.

In addition to steps (1) and (2), the method for producing the boron-doped single-crystal diamond film of the present invention may further include, after step (2), at least one of the following steps (3) and (4):
Step (3): shaping the deposited single-crystal diamond into a desired shape.
Step (4): Separating the substrate from the deposited single-crystal diamond containing boron.

The processing method to be used in step (3) is not specifically limited and may be, for example, laser processing or scaife polishing.

In the present invention, steps (1) and (2) can deposit a boron-doped single-crystal diamond on a substrate with a desired size or larger, and step (3) can shape the boron-doped single-crystal diamond into a desired size and shape. For example, cutting by a laser processing machine is employed to form a boron-doped single-crystal diamond with a specific area. Furthermore, for example, scaife polishing may be employed to adjust the surface roughness and the off-angle of the boron-doped single-crystal diamond film.

The processing method to be used in step (4) is not specifically limited and may be, for example, laser processing or scaife polishing.

Step (4) can be carried out, for example, to obtain the boron-doped single-crystal diamond film as a free-standing film. For example, the substrate is cut away from the boron-doped single-crystal diamond film with a laser processing machine, and then the surface roughness of the cut surface is adjusted by scaife polishing. In another example, the substrate is ground away by scaife polishing, without using a laser processing machine.

### Examples

The present invention will be hereinafter described in detail with reference to examples and a comparative example; however, the present invention is not limited to the examples.

### <Examples 1 and 2 (Production of Boron-Doped Single-Crystal Diamond Film)>

A boron-doped single-crystal diamond film was deposited on a {001} surface of a single-crystal diamond substrate by the microwave plasma chemical deposition method. After the film deposition, the surface of the boron-doped single-crystal diamond film was planarized by scaife polishing. Table 1 below shows the film deposition conditions, the boron concentration, the film thickness, the off-angle, and the resistivity of each boron-doped single-crystal diamond film.

### (Film Deposition Conditions)

- Carrier gas: hydrogen, methane (carbon source), 1% trimethylboron diluted with hydrogen (boron source), and oxygen (oxygen source)
- Total pressure: 125 Torr
- Substrate size: 6 × 6 mm
- Film deposition time: 15 hours
- Substrate off-angle: 3°
- Boron concentration in the substrate: < 1 × 10¹⁴ cm⁻³

**[Table 1]**

| | Ex. 1 | Ex. 2 |
|---|---|---|
| [CH₄]/[H₂] (%) in Gas Phase | 5.7 | 5.4 |
| [TMB]/[CH₄] (ppm) in Gas Phase | 10000 | 20000 |
| [O₂]/[CH₄] (%) in Gas Phase | 3 | 4 |
| Substrate Temperature (°C) | 930 | 940 |
| Boron Concentration (cm⁻³) in Film | 3.5×10²⁰ | 8.0×10²⁰ |
| Film Thickness (µm) | 48 | 51 |
| {001} Off-Angle (°) from Surface | 2.7 | 2.6 |
| Resistivity (mΩ cm) | 10.3 | 5.45 |

### (Analysis Conditions for Boron Concentration)

Measuring apparatus: CAMECA IMS-7f
Primary ion species: Cs+
Primary acceleration voltage: 15.0 kV
Detection region: 30 (µm φ)

### (Measurement Conditions for Film Thickness)

Measuring apparatus: Mitutoyo ID-SX
Measurement procedure: The thickness of the single-crystal diamond substrate before boron-doped diamond growth and the thickness of the diamond stack after growth were measured, and the difference between the thicknesses was determined as the film thickness.

### (Measurement Conditions for Off-Angle)

Measuring apparatus: Rigaku SmartLab
X-ray type: Cu-Kα
Measurement method: rocking curve measurement method

### (Measurement Conditions for Resistivity)

Measuring apparatus: MCP-T700; Mitsubishi Chemical Analytech
Measurement method: four-point probe method
Probe spacing: 1 mm

### <Example 3 (Production of Free-Standing Film of Boron-Doped Single-Crystal Diamond)>

A boron-doped single-crystal diamond film was deposited on a {001} surface of a single-crystal diamond substrate by the microwave plasma chemical deposition method. After the film deposition, the resulting substrate was cut into a size of 8.5 × 9.0 mm by a laser processing machine, and then the surface with the deposited film was planarized by scaife polishing. The substrate was removed by scaife polishing. Table 2 below shows the film deposition conditions, the boron concentration, the film thickness, the off-angle, and the resistivity of the boron-doped single-crystal diamond film.

### (Film Deposition Conditions)

- Carrier gas: hydrogen, methane (carbon source), 1% trimethylboron diluted with hydrogen (boron source), and oxygen (oxygen source)
- Total pressure: 125 Torr
- Substrate size: 21 × 21 mm
- Film deposition time: 82 hours
- Substrate off-angle: 3°
- Boron concentration in the substrate: < 1 × 10¹⁴ cm⁻³

**[Table 2]**

| | Ex. 3 |
|---|---|
| [CH₄]/[H₂] (%) in Gas Phase | 7.5 |
| [TMB]/[CH₄] (ppm) in Gas Phase | 8000 |
| [O₂]/[CH₄] (%) in Gas Phase | 3 |
| Substrate Temperature (°C) | 1020 |
| Boron Concentration (cm⁻³) in Film | 4.5×10²⁰ |
| Film Thickness (µm) | 423 |
| {001} Off-Angle (°) from Surface | 3.2 |
| Resistivity (mΩ cm) | 7.2 |

### <Measurement of Impurity Concentration>

For each of the boron-doped single-crystal diamond films obtained in Examples 1 to 3, the nitrogen concentration and the concentrations of metal elements (tungsten, tantalum, rhenium, ruthenium, and silicon) were measured by SIMS analysis. The results are shown in Table 3.

### (Analysis Conditions for Nitrogen and Silicon Concentrations)

Measuring apparatus: CAMECA IMS-7f
Primary ion species: Cs+
Primary acceleration voltage: 15.0 kV
Detection region: 30 (µm φ)

### (Analysis Conditions for Tungsten, Tantalum, Rhenium, and Ruthenium Concentrations)

Measuring apparatus: CAMECA IMS-7f
Primary ion species: O₂+
Primary acceleration voltage: 11.0 kV
Detection region: 30 (µm φ)

**[Table 3]**

| | Ex. 1 | Ex. 2 | Ex. 3 |
|---|---|---|---|
| Nitrogen Concentration (cm⁻³) | <1.0×10¹⁶ | <1.0×10¹⁶ | <1.0×10¹⁶ |
| Tungsten Concentration (cm⁻³) | <4.3×10¹⁵ | <4.3×10¹⁵ | <4.3×10¹⁵ |
| Tantalum Concentration (cm⁻³ ) | <1.3×10¹⁵ | <1.3×10¹⁵ | <1.3×10¹⁵ |
| Rhenium Concentration (cm⁻³) | <2.0×10¹⁵ | <2.0×10¹⁵ | <2.0×10¹⁵ |
| Ruthenium Concentration (cm⁻³) | <3.1×10¹⁵ | <3.1×10¹⁵ | <3.1×10¹⁵ |
| Silicon Concentration (cm⁻³) | <2.0×10¹⁵ | <2.0×10¹⁵ | <2.0×10¹⁵ |

All the element concentrations shown in Table 3 were below the detection limit (background level).

### <Comparative Example 1 (Production of Boron-Doped Single-Crystal Diamond Film)>

A boron-doped single-crystal diamond film was deposited on a {001} surface of a single-crystal diamond substrate by the microwave plasma chemical deposition method. Table 4 below shows the film deposition conditions, the boron concentration, the film thickness, and the resistivity of the boron-doped single-crystal diamond film.

### (Film Deposition Conditions)

- Carrier gas: hydrogen, methane (carbon source), and 1% trimethylboron diluted with hydrogen (boron source)
- Total pressure: 125 Torr
- Substrate size: 6 × 6 mm
- Film deposition time: 16.5 hours
- Substrate off-angle: 3°
- Boron concentration in the substrate: < 1 × 10¹⁴ cm⁻³

**[Table 4]**

| | Comp. Ex. 1 |
|---|---|
| [CH₄]/[H₂] (%) in Gas Phase | 7.5 |
| [TMB]/[CH₄] (ppm) in Gas Phase | 8000 |
| [O₂]/[CH₄] (%) in Gas Phase | 0 |
| Substrate Temperature (°C) | 950 |
| Film Thickness (µm) | 82 |
| Resistivity (mΩ cm) | 670 |

## Claims

1. A boron-doped single-crystal diamond film having:
a boron concentration of 2 × 10²⁰ atms/cm³ or more,
a metal element concentration of less than 1 × 10¹⁶ atms/cm³,
a nitrogen concentration of 0.2 ppm or less,
a thickness in a range of 10 to 500 µm, and
an off-angle in a {001} plane orientation in a range of 0.1 to 4.0°.

2. The boron-doped single-crystal diamond film according to claim 1, wherein one surface of the boron-doped single-crystal diamond film has an area of 9 mm² or more.

3. The boron-doped single-crystal diamond film according to claim 1 or 2, wherein the boron-doped single-crystal diamond film is a free-standing film.

4. The boron-doped single-crystal diamond film according to claim 1 or 2, wherein the boron-doped single-crystal diamond film is stacked on a single-crystal diamond substrate.

5. A diamond stack comprising a single-crystal diamond substrate; and the boron-doped single-crystal diamond film according to claim 1 or 2 stacked on the single-crystal diamond substrate.

6. A method for producing the boron-doped single-crystal diamond film according to claim 1 or 2, sequentially comprising:
step (1) of introducing a carrier gas containing at least a carbon source, a boron source, and an oxygen source into a vacuum apparatus in which a substrate is placed; and
step (2) of converting the carrier gas into a plasma to deposit a single-crystal diamond film containing boron on the substrate.

7. The method according to claim 6, further comprising, after the step (2), step (3) of separating the single-crystal diamond film containing boron from the substrate.
